# EUROPÄISCHE PATENTSCHRIFT

(11) **EP 4 278 386 B1**
(45) Veröffentlichungstag und Bekanntmachung des Hinweises auf die Patenterteilung: **31.07.2024**
(21) Anmeldenummer: 21844238.2
(22) Anmeldetag: 21.12.2021
(51) Int. Cl.: G06F 3/044, H10K 30/88, H10K 39/10, H10K 59/131, H10K 59/40, H10K 50/844

(54) **HALBLEITERMODUL UND VERFAHREN ZU DESSEN HERSTELLUNG**
SEMICONDUCTOR MODULE AND METHOD FOR PRODUCING SAME
MODULE SEMI-CONDUCTEUR ET SON PROCÉDÉ DE PRODUCTION

(30) Priorität: 21.01.2021 DE 102021200540
(43) Veröffentlichungstag der Anmeldung: 22.11.2023
(73) Patentinhaber: ASCA GmbH & Co. KG, 97318 Kitzingen (DE)
(72) Erfinder: PÄTZOLD, Ralph, 91154 Roth (DE); SCHILINSKY, Pavel, 28279 Bremen (DE); VAN DER WIEL, Bas Cedric, 90478 Nürnberg (DE)
(74) Vertreter: FDST Patentanwälte
(86) Internationale Anmeldenummer: PCT/EP2021/086934
(87) Internationale Veröffentlichungsnummer: WO 2022/156981

(56) Entgegenhaltungen:
- US-A1- 2017 010 712
- US-B1- 9 865 576

## Beschreibung

Die Erfindung betrifft ein Halbleitermodul, insbesondere ein organisches Photovoltaikmodul, sowie ein Gerät mit einem solchen Halbleitermodul und ein Verfahren zur Herstellung eines solchen Halbleitermoduls.

Ein Halbleitermodul weist üblicherweise eine Schichtstruktur mit zwei Elektrodenschichten und einer dazwischen angeordneten aktiven Schicht auf. Die Schichtstruktur realisiert eine bestimmte Funktion des Halbleitermoduls. Bei einem Photovoltaikmodul wird beispielsweise in der aktiven Schicht Licht absorbiert und dadurch ein Strom erzeugt, welcher über die Elektrodenschichten abgegriffen werden kann. Die Elektrodenschichten und die aktive Schicht werden bei der Herstellung des Halbleitermoduls typischerweise strukturiert, z.B. um bei einem Photovoltaikmodul mehrere Zellen auszubilden, welche dann seriell und/oder parallel miteinander verschaltet sind, um bestimmte elektrische Kennwerte (z.B. Strom oder Spannung) zu erzielen.

Grundsätzlich ist es wünschenswert, zusätzlich zu einer ersten, originären Funktion eines Halbleitermoduls dieses mit einer oder mehreren anderen Funktionen zu kombinieren. Beispielsweise ist bei einem Photovoltaikmodul die originäre Funktion die Stromerzeugung. Photovoltaikmodule finden vielfältig Anwendung und sind in verschiedenste Gegenstände, auch Alltagsgegenstände, integriert, um diese mit Strom zu versorgen. Beispielsweise ist es denkbar, eine Tastatur mit einem Photovoltaikmodul zu versehen, um diese Tastatur mit Strom zu versorgen. Die Tastatur bietet dann eine zusätzliche Funktion, nämlich eine Eingabemöglichkeit über entsprechende Tasten. Problematisch ist grundsätzlich, dass ein Photovoltaikmodul eine gewisse Fläche benötigt, um sinnvoll Strom zu erzeugen, wodurch die Möglichkeit zur Realisierung einer anderen Funktion an demselben Gegenstand eingeschränkt wird. Im Falle einer Tastatur würde konkret die Fläche, welche für Tasten zur Verfügung steht durch das Photovoltaikmodul reduziert, sodass gegebenenfalls die Tastatur vergrößert werden müsste.

In der US 2017/010712 A1 ist ein berührungsempfindlicher Sensor beschrieben.

Vor diesem Hintergrund ist es eine Aufgabe der Erfindung, ein verbessertes Halbleitermodul anzugeben, ein Gerät, welches ein solches Halbleitermodul nutzt, sowie ein Verfahren zur Herstellung eines solchen Halbleitermoduls. Das Halbleitermodul soll neben einer ersten, originären Funktion, noch mit einer zweiten Funktion ausgestattet sein. Dadurch soll eine möglichst hohe Funktionsdichte erzielt werden.

Die Aufgabe wird erfindungsgemäß gelöst durch ein Halbleitermodul mit den Merkmalen gemäß Anspruch 1, ein Gerät mit den Merkmalen gemäß Anspruch 11 sowie durch eine Verfahren mit den Merkmalen gemäß Anspruch 12. Vorteilhafte Ausgestaltungen, Weiterbildungen und Varianten sind Gegenstand der Unteransprüche. Die Ausführungen im Zusammenhang mit dem Halbleitermodul gelten sinngemäß auch für das Gerät sowie für das Verfahren und umgekehrt. Im Übrigen wird die Aufgabe insbesondere auch gelöst durch eine Verwendung des Halbleitermoduls in einem Gerät.

Das Halbleitermodul weist eine Schichtstruktur auf und zumindest einen kapazitiven Sensor. Die Schichtstruktur weist eine obere Elektrodenschicht und eine untere Elektrodenschicht auf sowie eine aktive Schicht, welche zwischen den Elektrodenschichten angeordnet ist und aus einem Halbleitermaterial hergestellt ist. Die aktive Schicht wird auch als funktionelle Schicht bezeichnet und bestimmt insbesondere eine erste, originäre Funktion des Halbleitermoduls. Der kapazitive Sensor realisiert dann eine weitere, andere Funktion.

Das Halbleitermodul ist bevorzugterweise als ein organisches Photovoltaikmodul ausgebildet und hierzu ist die Schichtstruktur zur Erzeugung von Strom mittels Absorption von Licht in der aktiven Schicht ausgebildet. Die aktive Schicht ist hierzu aus einem oder mehreren organischen Halbleitermaterialien gefertigt. Das Photovoltaikmodul dient demnach der Erzeugung von Energie durch Umwandlung von Licht. Die erste, originäre Funktion des Halbleitermoduls ist dann eine Stromerzeugung. Nachfolgend wird ohne Beschränkung der Allgemeinheit davon ausgegangen, dass das Halbleitermodul ein organisches Photovoltaikmodul ist, die Ausführungen gelten jedoch analog auch für nicht-organische Photovoltaikmodule und für andere organische und nicht-organische Halbleitermodule, z.B. OLED-Module oder elektronisches Papier (sogenanntes "E-Paper") und dergleichen. Bei einem OLED-Modul oder elektronischem Papier ist dann die erste, originäre Funktion eine Beleuchtung oder eine Anzeige z.B. von Bildern oder Informationen. Speziell ein organisches Halbleitermodul ist bevorzugt, da ein solches besonders flexibel gestaltbar ist, so ist vor allem das Design, d.h. die optische Anmutung des Halbleitermoduls weitgehend beliebig gestaltbar. Ein organische Halbleitermodul ist zudem besonders dünn, biegeflexibel und mechanisch robust. Auch die Herstellung weist deutliche Vorteile auf, so wird vorzugsweise ein "roll-to-roll"-Verfahren verwendet, welches eine hohe Fertigungsgeschwindigkeit aufweist.

Der kapazitive Sensor wird kurz auch lediglich als "Sensor" bezeichnet. Der Sensor dient vorzugsweise als Eingabeelement, insbesondere als Taste, und ist entsprechend durch eine Person von außen bedienbar, z.B. mit einem Finger. Der kapazitive Sensor ist somit insbesondere ein Berührungssensor, auch als Touch-Sensor bezeichnet. Entsprechend ist das Halbleitermodul mit integriertem Sensor ein berührungsempfindliches Halbleitermodul. Dem Sensor liegt das Prinzip zugrunde, dass eine Kapazitätsänderung erfasst wird, welche sich aus einer Änderung in der Umgebung des Sensors ergibt. Grundsätzlich sind hierfür zwei Elektroden erforderlich, welche zusammen einen Kondensator bilden, dabei ist es allerdings bereits ausreichend, wenn der eigentliche Sensor nur eine der beiden Elektroden aufweist und die andere Elektrode durch einen bewegten Gegenstand, z.B. einen Finger gebildet wird. Die Elektrode des Sensors wird als Messelektrode bezeichnet und ist insbesondere mit einer geeigneten Auswerteeinheit verbunden, deren genaue Ausgestaltung jedoch zunächst nicht weiter von Bedeutung ist. Eine Änderung im Umfeld (typischerweise in einem Abstand ≤ 1 mm) der Messelektrode führt in dieser typischerweise zu einer Ladungsverschiebung, welche dann mit der Auswerteeinheit gemessen wird. Auf diese Weise wird eine Annäherung eines Fingers an den Sensor und somit eine Betätigung des Eingabeelements erkannt.

Wie bereits angedeutet, weist der hier beschriebene kapazitive Sensor vorliegend eine Messelektrode auf. In einer geeigneten Ausgestaltung ist der Sensor identisch mit der Messelektrode, alternativ weist der Sensor noch eine Signalleitung auf, welche an die Messelektrode angeschlossen ist. Die Messelektrode ist in die Schichtstruktur integriert. Der Sensor ist somit vorteilhaft ein Teil der ohnehin schon bestehende Schichtstruktur des Halbleitermoduls. Diese Schichtstruktur realisiert zum einen die originäre Funktion des Halbleitermoduls und nun zusätzlich durch die Integration des Sensors noch eine weitere, andere Funktion. Im Beispiel des Photovoltaikmoduls mit Eingabeelement sind dann in der Schichtstruktur des Halbleitermoduls die beiden Funktionen "Stromerzeugung" und "Eingabefunktion" integriert.

Grundsätzlich ist es denkbar, eine weitere Funktion zu realisieren, indem ein entsprechendes Modul einfach auf ein Halbleitermodul aufgesetzt wird, beispielsweise indem eine separate Schichtstruktur mit einem kapazitiven Sensor auf eine Schichtstruktur eines Photovoltaikmoduls aufgesetzt wird. Die beiden Schichtstrukturen werden separat voneinander gefertigt und dann einfach zusammengesetzt. Vorliegend wird jedoch weiter gegangen und eine besonders tiefe Integration der weiteren Funktion realisiert, indem der kapazitative Sensor direkt in ebenjene Schichtstruktur integriert wird, welche eigentlich die originäre Funktion realisiert. Dabei wird ein Teil der Schichtstruktur sozusagen umgewidmet und der originären Funktion entzogen, um stattdessen eine andere Funktion zu realisieren. Dabei werden aber insbesondere keine anderen Materialien für den Sensor verwendet, sondern der Sensor wird geeigneterweise vollständig aus Materialien hergestellt, welche ohnehin zur Realisierung der originären Funktion verwendet werden. Im Beispiel des Photovoltaikmoduls wird dann insbesondere ein Teil der Schichtstruktur nicht mehr zur Stromerzeugung durch Absorption von Licht verwendet, sondern als kapazitiver Sensor, speziell als Eingabeelement. Aufgrund der hohen Integration ist die Herstellung des Halbleitermoduls auch besonders einfach, denn die Herstellung des kapazitiven Sensors erfolgt vorteilhafterweise gleichzeitig mit der Herstellung der Schichtstruktur. Hierbei wird die Erkenntnis genutzt, dass in einem Halbleitermodul, speziell innerhalb dessen Schichtstruktur, bereits leitendes Material an verschiedenen Stellen verwendet wird, welches sich durch geeignete Maßnahmen bei der Herstellung entsprechend umwidmen lässt und dadurch dann als Messelektrode eines kapazitiven Sensors nutzbar ist. Der Aufwand zur Herstellung des Sensors ist dann besonders gering. Nachteilig daran ist alleinig, dass möglicherweise ein Teil der Schichtstruktur für die originäre Funktion verloren geht, dies wird jedoch vorliegend in Kauf genommen.

Nachfolgend wird zunächst eine bevorzugte Ausgestaltung eines grundsätzlich zur Herstellung eines Halbleitermoduls, speziell eines organischen Photovoltaikmoduls, geeigneten Verfahrens beschrieben. Grundsätzlich können einzelne Schritte davon unabhängig voneinander verwendet, modifiziert, ersetzt oder ausgelassen werden.

Vorzugsweise wird bei der Herstellung des Halbleitermoduls in einem ersten Schritt die obere Elektrodenschicht ausgebildet, und zwar aus einem leitenden Material. Die obere Elektrodenschicht wird bevorzugterweise aus einem transparenten Material, vorzugsweise ITO, IMI oder ähnliches, und somit als transparente Elektrodenschicht gefertigt. Das Material wird insbesondere auf eine Trägerschicht aufgetragen, welche ebenfalls aus einem transparenten, jedoch elektrisch isolierenden Material gefertigt ist, insbesondere einem Kunststoff, z.B. PET. Die Trägerschicht ist üblicherweise 2 bis 3 Größenordnungen dicker als die Elektrodenschicht und dient vor allem als robuste Unterlage während der Herstellung.

Auf den ersten Schritt folgt vorzugsweise ein zweiter Schritt, in welchem die aktive Schicht auf die obere Elektrodenschicht aufgetragen wird. Die aktive Schicht wird aus einer oder mehreren Einzelschichten gefertigt, welche jeweils aus einem aktiven Material bestehen. Typischerweise besteht die aktive Schicht aus einer Mischung zweier unterschiedlicher aktiver Materialien. Die aktiven Materialien sind vorzugsweise organische Halbleitermaterialien. Die Einzelschichten und somit die aktive Schicht insgesamt werden mit einer Auftraganlage aufgetragen, vorzugsweise mittels "slot-die coating" oder einem vergleichbaren Verfahren.

Die obere Elektrodenschicht wird entweder direkt strukturiert ausgebildet oder zunächst durchgängig gefertigt, d.h. unstrukturiert, und eine Unterteilung in mehrere Elektroden, welche elektrisch voneinander getrennt sind, erfolgt dann beispielsweise nach dem Auftragen auf die Trägerschicht und vor dem Auftragen der aktiven Schicht oder alternativ nach dem Auftragen der aktiven Schicht. Eine Strukturierung der oberen Elektrodenschicht vor dem Auftragen der aktiven Schicht wird kurz als P1 bezeichnet. Eine Strukturierung der oberen Elektrodenschicht nach dem Auftragen der aktiven Schicht wird dagegen kurz als P1* bezeichnet. Ein P1-Strukturierungsschritt und ein P1*-Strukturierungsschritt führen üblicherweise zu vergleichbar guten Ergebnissen führt, ein P1*-Strukturierungsschritt hat aber während der Herstellung spezielle Vorteile. Beim Strukturieren der oberen Elektrodenschicht wird eine Anzahl von Trennstellen ausgebildet, welche die obere Elektrodenschicht in mehrere obere Elektroden unterteilen. Dazu wird das Material der oberen Elektrodenschicht bereichsweise entfernt, sodass an einer jeweiligen Trennstelle eine Ausnehmung in der oberen Elektrodenschicht entsteht.

In einem dritten Schritt wird vorzugsweise die aktive Schicht derart strukturiert, dass eine Anzahl an Kontaktstellen ausgebildet wird, an welchen die obere Elektrodenschicht freigelegt wird. Mit anderen Worten: die aktive Schicht wird an einer Anzahl an Kontaktstellen durchbrochen, ohne dabei die obere Elektrodenschicht zu durchbrechen, um später mit der unteren Elektrodenschicht kontaktiert zu werden. Die Strukturierung der aktiven Schicht, wobei die aktive Schicht vollständig durchbrochen wird, wird auch als zweiter Strukturierungsschritt, kurz P2 bezeichnet. Ein P1*- Strukturierungsschritt - sofern genutzt - wird zweckmäßigerweise gleichzeitig zum P2- Strukturierungsschritt durchgeführt.

Im dritten Schritt wird je nach Ausgestaltung vorzugsweise die aktive Schicht zusätzlich an Teilunterbrechungsstellen lediglich teilweise durchbrochen, d.h., dass zumindest eine der Einzelschichten durchbrochen wird, eine andere der Einzelschichten jedoch nicht, d.h. intakt bleibt. Eine solche Strukturierung der aktiven Schicht, wobei die aktive Schicht lediglich teilweise durchbrochen wird, wird auch als dritter Strukturierungsschritt, kurz P3 bezeichnet.

Auf den dritten Schritt folgt vorzugsweise ein vierter Schritt, in welchem auf die aktive Schicht dann die untere Elektrodenschicht aufgetragen wird. Die untere Elektrodenschicht wird aus einem leitenden Material gefertigt, vorzugsweise aus einem Metall, besonders bevorzugt aus Silber. Die untere Elektrodenschicht wird vorzugsweise als Gitterelektrode ausgebildet. Zweckmäßigerweise wird die untere Elektrodenschicht bereits strukturiert ausgebildet, d.h. mit mehreren oberen Elektroden, analog zur oberen Elektrodenschicht. Eine nachträgliche Strukturierung analog zur oberen Elektrodenschicht ist aber auch denkbar und geeignet.

Die Kennzeichnung der Elektrodenschichten als obere und untere Elektrodenschicht ist im Grunde willkürlich. Die hier gewählte Kennzeichnung geht davon aus, dass die obere Elektrodenschicht die vorrangig nach vorn gewandte und sichtbare Schicht auf der Vorderseite des Halbleitermoduls ist, über welche dann auch bei einem Photovoltaikmodul Licht einfällt oder bei einem OLED-Modul Licht ausgegeben wird. Die untere Elektrodenschicht liegt dann darunter oder dahinter und auf einer Rückseite des Halbleitermoduls.

Abschließend wird der Stapel aus Trägerschicht, aktiver Schicht und Elektrodenschichten zweckmäßigerweise in einem fünften Schritt eingekapselt, nämlich mit einer Schutzhülle umgeben, um die Anordnung vor Umwelteinflüssen, z.B. der Witterung, zu schützen. Die Schutzhülle ist beispielsweise aus einem transparentem Kunststoff gefertigt, z.B. PET, alternativ auf zumindest einer Seite aus einem Metall, welches einen besonders guten Schutz bietet, jedoch nicht lichtdurchlässig ist und daher geeigneterweise nur auf der Rückseite verwendet wird. Alternativ wird die Schutzhülle auf der Vorderseite durch die Trägerschicht gebildet und nur auf der Rückseite eine zusätzliche Schutzschicht aufgetragen.

Die beiden Elektrodenschichten und gegebenenfalls auch die Schutzhülle sind also jeweils aus einem leitenden Material gefertigt und sind daher jeweils zur Ausbildung der Messelektrode des Sensors geeignet.

Bevorzugterweise ist die Messelektrode potentialfrei, dies wird auch als "floating voltage" bezeichnet. Demnach wird unter "potentialfrei" verstanden, dass die Messelektrode gerade nicht mit einem Bezugspotential, speziell einem Massepotential, verbunden ist, sondern vielmehr unabhängig ist. Zur Ausbildung eines kapazitiven Sensors ist dies völlig ausreichend. Das bedeutet aber insbesondere auch, dass die Messelektrode nicht mit einem Potential des übrigen Halbleitermoduls verbunden ist, sondern hiervon galvanisch getrennt und somit unabhängig ist. Beispielsweise weist ein Photovoltaikmodul einen Pluspol und einen Minuspol auf, welche durch die Elektroden der beiden Elektrodenschichten gebildet werden. Die Messelektrode ist dann weder mit dem Pluspol noch mit dem Minuspol verbunden. Sofern der Sensor nur eine einzige Messelektrode aufweist, weist das Halbleitermodul vorzugsweise auch lediglich einen einzelnen Anschlusspol, d.h. einen lediglich einpoligen Anschluss, für den Sensor auf.

Da die Elektrodenschichten typischerweise ohnehin zur Realisierung der originären Funktion des Halbleitermoduls strukturiert werden, wird dabei zweckmäßigerweise auch die Messelektrode des Sensors ausgebildet und hierzu sozusagen aus einer der Elektrodenschichten herausgeschnitten und vom Rest der Elektrodenschicht elektrisch isoliert. In einer geeigneten Ausgestaltung hierfür ist bei dem Halbleitermodul zumindest eine der Elektrodenschichten strukturiert und weist dadurch mehrere Teilbereiche auf, welche galvanisch voneinander getrennt sind. Einer der mehreren Teilbereiche bildet dann die Messelektrode. Dadurch ist die Messelektrode in die Schichtstruktur integriert. Die übrigen Teilbereiche (je nach Ausgestaltung einer oder mehrere) bilden dann jeweils insbesondere eine Elektrode einer jeweiligen Zelle des Halbleitermoduls.

Zweckmäßigerweise ist die andere Elektrodenschicht ebenfalls strukturiert, insbesondere in analoger Weise, speziell derart, dass auch dabei für jede Zelle des Halbleitermoduls eine Elektrode ausgebildet ist. Für eine Messelektrode als Teilbereich einer der Elektrodenschichten muss aber nicht zwingend ein Gegenstück in der anderen Elektrodenschicht hergestellt werden, d.h. die Anzahl der Teilbereiche in den beiden Elektrodenschichten muss nicht zwingend gleich sein, sodass dann die Messelektroden nur einlagig ist, in einer bevorzugten Ausgestaltung ist dies aber der Fall und die Messelektrode ist doppellagig und ist dabei zusammengesetzt aus je einem Teilbereich in beiden Elektrodenschichten. Bei der Ausbildung der Messelektrode in einer der Elektrodenschichten ist der Sensor dann unmittelbar in die Schichtstruktur integriert. Die Messelektrode befindet sich räumlich in einer Ebene mit den Elektroden der entsprechenden Elektrodenschicht. Auch besteht die Messelektrode dann aus dem gleichen Material, aus welchem die Elektrodenschicht hergestellt ist.

Die Elektrodenschicht wird geeigneterweise dadurch strukturiert, dass diese zunächst flächig, d.h. durchgängig aufgetragen ist und dann nachträglich in einem Strukturierungsschritt teilweise entfernt wird, z.B. mittels eines Lasers. Dies wird vorzugsweise bei der oberen Elektrodenschicht durchgeführt, z.B. wie oben als P1- oder P1*-Strukturierungsschritt beschrieben. Alternativ wird die Elektrodenschicht dadurch strukturiert, dass diese von vornherein strukturiert, d.h. dann lediglich bereichsweise, aufgetragen wird. Dies wird vorzugsweise bei der unteren Elektrodenschicht durchgeführt, wie oben im Zusammenhang mit dem vierten Schritt bei der Herstellung beschrieben ist. In einer anderen, geeigneten Ausgestaltung wird die Messelektrode in einem zusätzlichen Strukturierungsschritt hergestellt., beispielsweise nach dem Auftragen der unteren Elektrode.

Die Größe, d.h. die Abmessung der Messelektrode ist im Grunde beliebig gestaltbar und daher zweckmäßigerweise an den vorgesehenen Anwendungsfall angepasst. Vorzugsweise wird dabei die Größe der Messelektrode jedoch so gering wie möglich gewählt, um möglichst viel Fläche des Halbleitermoduls für dessen erste, originäre Funktion zu erhalten. Bei der Verwendung des Sensors als Eingabeelement, speziell zur Bedienung mit einem Finger, ist es ausreichend und daher zweckmäßig, wenn die Messelektrode mit quadratischer Form mit einer Kantenlänge von 1 mm bis 10 mm ausgebildet ist oder in anderer Form mit gleich großer Fläche.

Vorliegend ist die Messelektrode aus einem Oberteil, welches ein Teilbereich der oberen Elektrodenschicht ist, und einem Unterteil, welches ein Teilbereich der unteren Elektrodenschicht ist, gebildet, wobei das Oberteil und das Unterteil mittels einer Durchkontaktierung durch die aktive Schicht hindurch elektrisch verbunden sind. In dieser Ausgestaltung ist die Herstellung der Messelektrode vollständig in die Herstellung des Halbleitermoduls integrierbar und insbesondere auch integriert, speziell wird die Messelektrode vollständig durch solche Verfahrensschritte hergestellt, welche auch zur Herstellung der Zellen verwendet werden, z.B. wie weiter oben bereits beschrieben.

Allgemein ist die Schichtstruktur vorzugsweise strukturiert, sodass diese mehrere Zellen aufweist. Die Durchkontaktierung ist dabei dann geeigneterweise gemeinsam mit einer oder mehreren weiteren Durchkontaktierungen hergestellt, mittels welcher die Zellen elektrisch verschaltet sind. Die Durchkontaktierungen zum Verbinden der Zellen werden auch als Zell-Durchkontaktierungen bezeichnet. Beide Elektrodenschichten werden jeweils strukturiert, um die Elektroden der Zellen auszubilden, zugleich werden dabei das Oberteil und das Unterteil analog zu den Elektroden ausgebildet, gegebenenfalls mit abweichender Form. Weiter werden ein oder mehrere Durchkontaktierungen ausgebildet, welche durch die aktive Schicht hindurchreichen und die Elektroden elektrisch miteinander verbinden, um die Zellen seriell oder parallel zu verschalten oder eine Kombination hiervon. Dabei wird dann auch eine Durchkontaktierung ausgebildet, welche das Oberteil mit dem Unterteil verbindet, sodass diese dann kurzgeschlossen sind. Das Oberteil und das Unterteil sind sozusagen blinde Elektroden, da diese im Grunde wie Elektroden hergestellt werden, jedoch nicht mit den übrigen Elektroden der Zellen elektrisch verbunden werden und insofern also nicht für die originäre Funktion des Halbleitermoduls genutzt werden, sondern nur für die zusätzliche, andere Funktion. Das Oberteil und das Unterteil sind vorzugsweise übereinanderliegend ausgebildet und gerade nicht zueinander versetzt. Geeigneterweise sind das Oberteil und das Unterteil auch gleich groß und/oder weisen die gleiche Form auf, abgesehen von fertigungstechnisch bedingten Toleranzen und Unterschieden.

Abseits der Möglichkeit, mittels der Durchkontaktierung das Oberteil und das Unterteil kurzzuschließen und diese dadurch zu einer einzelnen Messelektrode zu vereinen, wird die Durchkontaktierung vorzugsweise auch genutzt, um einem Benutzer die Position des Sensors anzuzeigen. In einer geeigneten Ausgestaltung ist hierzu die Durchkontaktierung von außen sichtbar und markiert dadurch die Position des kapazitiven Sensors im Halbleitermodul. Dies ist besonders vorteilhaft bei einer Verwendung des Sensors als Eingabeelement. Die Durchkontaktierung wird hier demnach gezielt als Markierung verwendet. Eine zusätzliche Markierung, z.B. eine Bedruckung oder dergleichen, ist dann entbehrlich und wird vorzugsweise ausgelassen. Auf diese Weise ist auch die Markierung des Sensors vollständig in die Herstellung des Halbleitermoduls integriert, sodass hierzu kein separater Verfahrensschritt nötig ist. Die Markierung des Sensors erfolgt vielmehr bei der Herstellung der Durchkontaktierungen.

Die beschriebene Markierung mittels einer Durchkontaktierung ist auch möglich, wenn die Messelektrode nur aus einer der Elektrodenschichten hergestellt ist. Entsprechend dient die Durchkontaktierung dann nicht zum Kurzschließen von Teilbereichen der oberen und unteren Elektrodenschicht, sondern es ist nur ein Oberteil oder nur ein Unterteil vorhanden, die Durchkontaktierung ist aber trotzdem von außen sichtbar ist und markiert dadurch die Position des kapazitiven Sensors im Halbleitermodul. Nachfolgend wird ohne Beschränkung der Allgemeinheit von einer Messelektrode mit Oberteil und Unterteil ausgegangen, die Ausführungen gelten aber auch analog für eine Messelektrode nur mit Oberteil oder nur mit Unterteil.

Bevorzugterweise ist die obere Elektrodenschicht aus einem transparenten Material gefertigt, sodass die Durchkontaktierung und die aktive Schicht durch die obere Elektrodenschicht hindurch, d.h. insbesondere von außen, sichtbar sind. Unter "transparent" wird insbesondere "lichtdurchlässig im sichtbaren Spektralbereich" verstanden. Weiter ist die Durchkontaktierung vorzugsweise aus einem anderen Material als die aktive Schicht hergestellt und hebt sich dadurch gegenüber der aktiven Schicht optisch ab. Wesentlich hierbei ist, dass die Materialien der aktiven Schicht und der Durchkontaktierung derart unterschiedlich sind, dass diese einen optischen Kontrast erzeugen und dadurch die Durchkontaktierung von einem Anwender gegen die aktive Schicht visuell abgrenzbar ist. In einer geeigneten Ausgestaltung weisen die aktive Schicht und die Durchkontaktierung hierzu unterschiedliche Farben auf.

Eine jeweilige Durchkontaktierung wird insbesondere dadurch hergestellt, dass die aktive Schicht in einem Strukturierungsschritt strukturiert wird, d.h. das aktive Material bereichsweise entfernt oder von vornherein ausgelassen wird, und stattdessen dann elektrisch leitendes Material eingefügt wird. Bevorzugterweise ist die Durchkontaktierung der Messelektrode gleichzeitig mit der unteren Elektrodenschicht hergestellt und ist somit automatisch aus dem gleichen Material wie die untere Elektrodenschicht hergestellt. Bei einem Photovoltaikmodul mit einer unteren Elektrodenschicht aus Silber ist dann die Durchkontaktierung ebenfalls aus Silber hergestellt und visuell gut gegen das Material der aktiven Schicht abgegrenzt. Speziell bei einem Metall wie z.B. Silber ergibt sich eine besonders vorteilhafte optische Anmutung, da eine Durchkontaktierung aus Metall eine entsprechende Lichtreflexion hervorruft, wohingegen das aktive Material typischerweise eher matt erscheint.

Besonders zweckmäßig ist eine Ausgestaltung, bei welcher die Durchkontaktierung in Form eines Schriftzeichens oder Bildzeichens ausgebildet ist. Dadurch lässt sich nicht nur die Position des Sensors anzeigen, sondern auch eine damit verknüpfte Funktion angeben. Dies ist besonders sinnvoll bei einem Sensor, welcher als Eingabeelement dient, speziell als Taste, durch deren Betätigung z.B. eine bestimmte Funktion des jeweiligen Gerätes aktiviert oder deaktiviert wird. Diese Funktion ist dann mittels der Durchkontaktierung unmittelbar dargestellt. Grundsätzlich ist es auch vorteilhaft, mehrere Durchkontaktierungen für einen einzelnen Sensor auszubilden, um komplexere Bilder oder Kombinationen mehrerer Schriftzeichen darzustellen.

In einer geeigneten, beispielhaften Ausgestaltung ist das Gerät eine Tastatur, welche ein Halbleitermodul mit mehreren kapazitiven Sensoren aufweist, welche als Eingabeelemente für einen Mediaplayer dienen. Entsprechend ist die Durchkontaktierung eines der Sensoren mit einem "P" oder einem Pfeil ">" für die Funktion "Wiedergabe" markiert und ein anderer Sensor mit einem "F" oder">|" für die Funktion "weiter", "FF" oder ">>" für die Funktion "Vorspulen" und so weiter.

Geeigneterweise weist das Halbleitermodul rückseitig eine Ausnehmung auf, zum Anschließen der Messelektrode an eine Auswerteeinheit. Die Ausnehmung wird auch als "Kontaktloch" bezeichnet. Die Ausnehmung ist insbesondere in eine Schutzhülle des Halbleitermoduls eingebracht, sodass die Messelektrode elektrisch zugänglich ist. Analog weist das Halbleitermodul zweckmäßigerweise auch eine, vorzugsweise zwei Ausnehmungen zum Anschließen der Zellen, genauer deren Elektroden auf, d.h. Ausnehmungen für einen Pluspol und einen Minuspol des Halbleitermoduls.

Alternativ oder zusätzlich zu der beschriebenen Ausbildung der Messelektrode aus einer oder beiden der Elektrodenschichten ist die Messelektrode aus einer leitenden Seite einer Schutzhülle ausgebildet. In einer geeigneten Ausgestaltung weist die Schichtstruktur entsprechend eine Schutzhülle auf, welche eine Außenhülle des Halbleitermoduls ist, zum Schutz gegen Umwelteinflüsse, und die Schutzhülle weist zumindest eine Seite auf, welche aus einem leitenden Material hergestellt ist und welche die Messelektrode bildet. Das Material ist insbesondere ein Metall, beispielsweise Aluminium, welches besonders gute Barriereeigenschaften hat. Da das Material elektrisch leitend ist und von den Elektrodenschichten galvanisch getrennt ist, ist es entsprechend ebenfalls als Messelektrode geeignet. Grundsätzlich ist eine Schutzhülle als Messelektrode auch mit einer oder mehreren Messelektroden in einer oder beiden Elektrodenschichten kombinierbar.

Das erfindungsgemäße Gerät ist insbesondere ein Eingabegerät, beispielsweise eine Tastatur, uns weist ein Halbleitermodul wie vorstehend beschrieben auf.

Dabei dient der kapazitive Sensor als ein Eingabeelement, insbesondere als Taste. Weiter weist das Gerät zweckmäßigerweise eine Auswerteeinheit wie bereits beschrieben auf, an welche die Messelektrode angeschlossen ist, zur Auswertung eines Signals des Sensors. Ein solches Signal ist insbesondere eine Spannung, welche sich bei einer Betätigung des Sensors ändert. Die Auswerteeinheit misst entsprechend die Spannung und prüft wiederkehrend, ob sich diese ändert und ob also eine Eingabe vorgenommen wurde.

Das erfindungsgemäße Verfahren dient zur Herstellung eines Halbleitermoduls wie vorstehend beschrieben. Das Halbleitermodul weist entsprechend eine Schichtstruktur auf und zumindest einen kapazitiven Sensor. Die Schichtstruktur weist eine obere Elektrodenschicht und eine untere Elektrodenschicht auf sowie eine aktive Schicht, welche zwischen den Elektrodenschichten angeordnet ist und aus einem Halbleitermaterial hergestellt ist. Der kapazitive Sensor weist eine Messelektrode auf. Ein wesentlicher Verfahrensschritt ist dann, dass die Messelektrode in die Schichtstruktur integriert wird. Zweckmäßige Ausgestaltungen und Details ergeben sich aus dem bereits Gesagten.

Nachfolgend werden Ausführungsbeispiele der Erfindung anhand einer Zeichnung näher erläutert. Darin zeigen jeweils schematisch:
- Fig. 1: einen Ausschnitt eines Halbleitermoduls in einer Frontansicht,
- Fig. 2: einen Ausschnitt des Halbleitermoduls aus Fig. 1 in einer Rückansicht,
- Fig. 3: das gesamte Halbleitermodul aus Fig. 1 in einer Rückansicht,
- Fig. 4: das Halbleitermodul aus Fig. 1 in einer ersten Schnittansicht,
- Fig. 5: das Halbleitermodul aus Fig. 1 in einer zweiten Schnittansicht,
- Fig. 6: ein Verfahren zur Herstellung des Halbleitermoduls aus Fig. 1,
- Fig. 7: ein Gerät mit einem Halbleitermodul wie in Fig. 1.

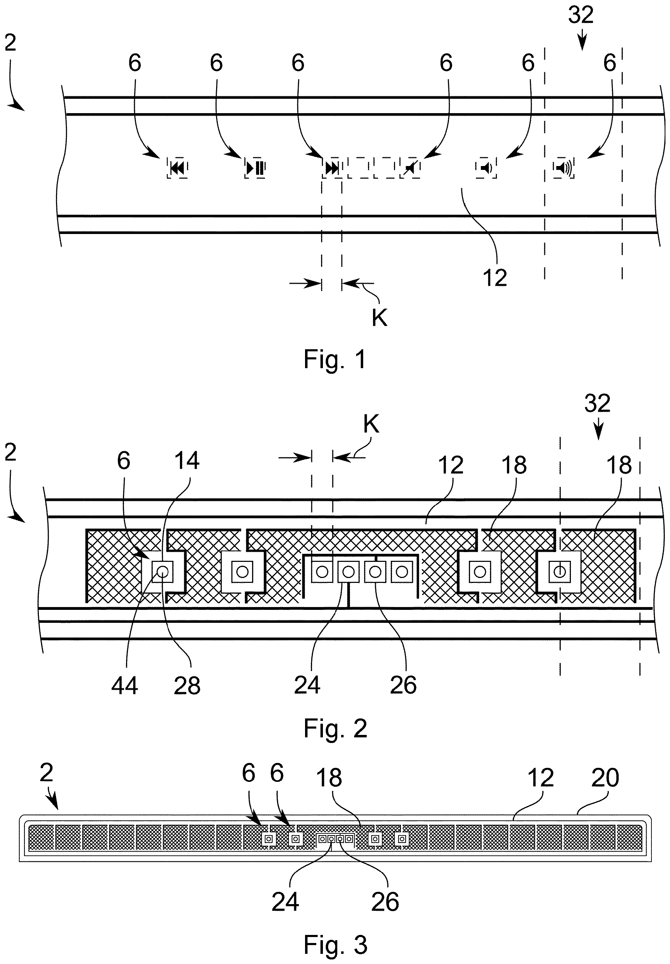

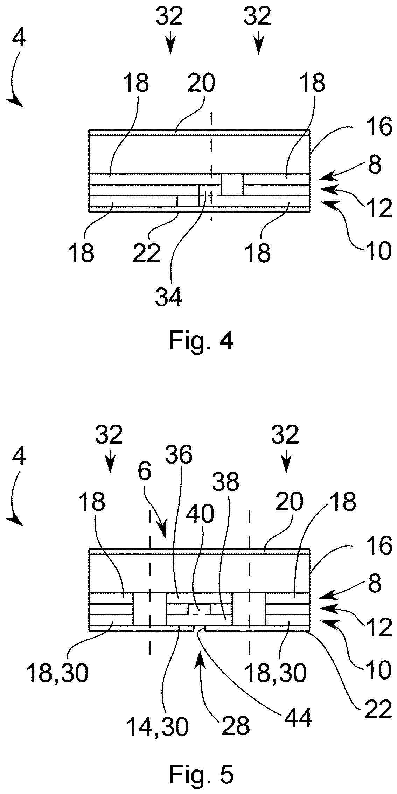

In Fig. 1 ist ein Halbleitermodul 2 ausschnittsweise in einer Frontansicht gezeigt, in Fig. 2 ist dieses Halbleitermodul ebenfalls ausschnittsweise in einer Rückansicht gezeigt. Fig. 3 zeigt das gesamte Halbleitermodul 2 in der Rückansicht. Das Halbleitermodul 2 weist eine Schichtstruktur 4 auf, welche speziell in den beiden Schnittansichten der Fig. 4 und 5 erkennbar ist. In den Fig. 4 und 5 ist die Vorderseite oder Oberseite des Halbleitermoduls 2 jeweils oben, die Rückseite oder Unterseite entsprechend jeweils unten. Weiter weist das Halbleitermodul 2 zumindest einen kapazitiven Sensor 6 auf, welcher kurz auch nur als "Sensor" bezeichnet wird. Die Schichtstruktur 4 weist eine obere Elektrodenschicht 8 und eine untere Elektrodenschicht 10 auf sowie eine aktive Schicht 12. Die aktive Schicht 12 bestimmt eine erste, originäre Funktion des Halbleitermoduls 2, der kapazitive Sensor 6 realisiert dann eine weitere, andere Funktion.

Das hier gezeigte Halbleitermodul 2 ist als ein organisches Photovoltaikmodul ausgebildet und entsprechend ist die Schichtstruktur 4 zur Erzeugung von Strom mittels Absorption von Licht in der aktiven Schicht 12 ausgebildet. Die aktive Schicht ist hierzu aus einem oder mehreren organischen Halbleitermaterialien gefertigt. Die erste, originäre Funktion des Halbleitermoduls 2 ist dann eine Stromerzeugung. Die hier gemachten Ausführungen gelten jedoch analog auch für nicht-organische Photovoltaikmodule und für andere organische und nicht-organische Halbleitermodule 2, z.B. OLED-Module oder elektronisches Papier und dergleichen.

Der Sensor 6 dient hier als Eingabeelement, speziell als Taste, und ist entsprechend durch eine Person von außen bedienbar, z.B. mit einem Finger. Dem Sensor 6 liegt das Prinzip zugrunde, dass eine Kapazitätsänderung erfasst wird, welche sich aus einer Änderung in der Umgebung des Sensors 6 ergibt. Der Sensor 6 weist eine Messelektrode 14 auf, welche in die Schichtstruktur 4 integriert ist. Der Sensor 6 ist somit ein Teil der ohnehin schon bestehenden Schichtstruktur 4. Im Ausführungsbeispiel des Photovoltaikmoduls mit Eingabeelement sind dann in der Schichtstruktur 4 des Halbleitermoduls 2 die beiden Funktionen "Stromerzeugung" und "Eingabefunktion" integriert. Das hier gezeigte Halbleitermodul 2 weist sechs Sensoren 6 auf, welche zudem gleichartig ausgebildet sind, möglich sind aber auch andere Anzahlen an Sensoren 6 und/oder andere, auch unterschiedliche Ausgestaltungen der Sensoren 6 sowie andere Anordnungen.

Vorliegend ist der kapazitative Sensor 6 direkt in ebenjene Schichtstruktur 4 integriert wird, welche eigentlich die originäre Funktion des Halbleitermoduls 2 realisiert. Dabei wird ein Teil der Schichtstruktur 4 sozusagen umgewidmet und der originären Funktion entzogen, um stattdessen eine andere Funktion zu realisieren. Dabei werden vorliegend auch keine anderen Materialien für den Sensor 6 verwendet, sondern dieser wird vollständig aus Materialien hergestellt, welche ohnehin zur Realisierung der originären Funktion verwendet werden. Im gezeigten Ausführungsbeispiel wird dann ein Teil der Schichtstruktur 4 nicht mehr zur Stromerzeugung durch Absorption von Licht verwendet, sondern als kapazitiver Sensor 6.

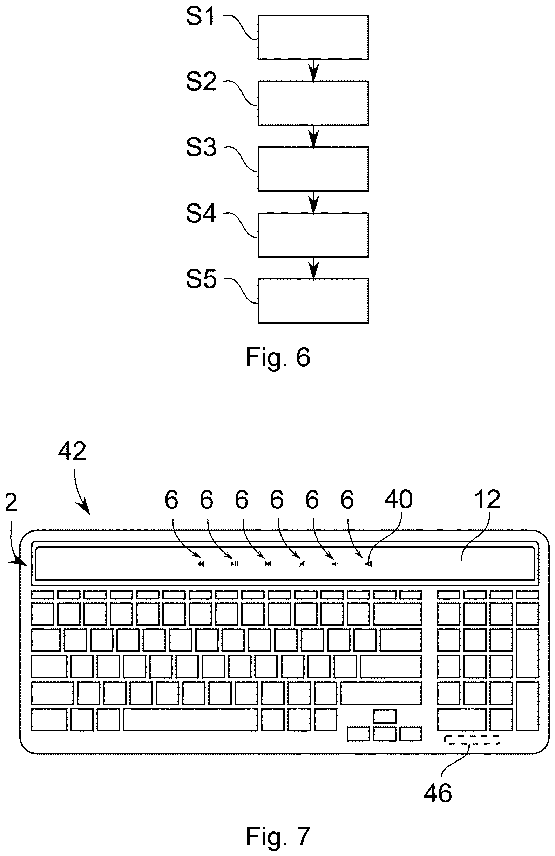

Nachfolgend wird zunächst eine mögliche Ausgestaltung eines Verfahrens zur Herstellung des Halbleitermoduls 2 beschrieben. Das Verfahren ist in Fig. 6 als Flussdiagramm wiedergegeben. Grundsätzlich können einzelne Schritte davon unabhängig voneinander verwendet, modifiziert, ersetzt oder ausgelassen werden.

In einem ersten Schritt S1 wird die obere Elektrodenschicht 8 ausgebildet, und zwar hier aus einem leitenden und transparente Material, z.B. IMI oder ITO. Das Material wird auf eine Trägerschicht 16 aufgetragen, welche ebenfalls aus einem transparenten, jedoch elektrisch isolierenden Material gefertigt ist, hier einem Kunststoff, z.B. PET. Auf den ersten Schritt S1 folgt ein zweiter Schritt S2, in welchem die aktive Schicht 12 auf die obere Elektrodenschicht 8 aufgetragen wird.

Die obere Elektrodenschicht 8 wird entweder direkt im ersten Schritt S1 strukturiert ausgebildet oder alternativ zunächst durchgängig gefertigt, d.h. unstrukturiert, und eine Unterteilung in mehrere Elektroden 18, welche elektrisch voneinander getrennt sind, erfolgt dann beispielsweise nach dem Auftragen auf die Trägerschicht 16 und vor dem Auftragen der aktiven Schicht 12 z.B. noch im ersten Schritt S1 oder alternativ nach dem Auftragen der aktiven Schicht 12, z.B. im zweiten Schritt S2. Die Strukturierung der oberen Elektrodenschicht 8 erfolgt insbesondere in einem Strukturierungsschritt P1 oder P1*

In einem dritten Schritt S3 wird die aktive Schicht 12 derart strukturiert, dass eine Anzahl an Kontaktstellen ausgebildet wird, an welchen die obere Elektrodenschicht 8 freigelegt wird. Mit anderen Worten: die aktive Schicht 12 wird an einer Anzahl an Kontaktstellen durchbrochen, um später mit der unteren Elektrodenschicht 10 kontaktiert zu werden. Im dritten Schritt S3 werden insbesondere einer oder mehrere der bereits beschriebenen Strukturierungsschritte P1 *, P2, P3 durchgeführt.

Auf den dritten Schritt S3 folgt ein vierter Schritt S4, in welchem auf die aktive Schicht 12 dann die untere Elektrodenschicht 10 aufgetragen wird. Die untere Elektrodenschicht 10 wird aus einem leitenden Material gefertigt, hier aus einem Metall, speziell Silber. Die untere Elektrodenschicht 10 wird hier zudem als Gitterelektrode ausgebildet und auch bereits im vierten Schritt S4 strukturiert ausgebildet, d.h. mit mehreren oberen Elektroden 18, analog zur oberen Elektrodenschicht 8. In den Figuren werden die verschiedenen Elektroden 18 der Einfachheit halber nicht unterschiedlich bezeichnet.

Abschließend wird im gezeigten Ausführungsbeispiel der Stapel aus Trägerschicht 16, aktiver Schicht 12 und Elektrodenschichten 8, 10 in einem fünften Schritt S5 eingekapselt, nämlich mit einer Schutzhülle 20 umgeben, um die Anordnung vor Umwelteinflüssen, z.B. der Witterung, zu schützen. Die Schutzhülle 20 ist aus einem transparentem Kunststoff gefertigt, z.B. PET, alternativ auf zumindest einer Seite 22 aus einem Metall, welches allerdings gegenüber den Elektrodenschichten 8, 10 isoliert ist, z.B. indem die Seite 22 eine metallbeschichtete Kunststofffolie ist.

Die beiden Elektrodenschichten 8, 10 und gegebenenfalls auch die Schutzhülle 20 sind also jeweils aus einem leitenden Material gefertigt und sind daher jeweils zur Ausbildung der Messelektrode 14 des Sensors 6 geeignet. Im hier gezeigten Ausführungsbeispiel wird der Sensor 6 aus den Elektrodenschichten 8, 10 hergestellt. Dies ist speziell in der Schnittansicht in Fig. 5 erkennbar. Die Herstellung des Sensors 6 ist dabei auf diejenigen Schritte des Verfahrens verteilt, in welchen die Elektrodenschichten 8, 10 ausgebildet und strukturiert werden. Eine Ausführungsform, bei welcher die Seite 22 der Schutzhülle 20 als Sensor 6 dient, ist nicht explizit gezeigt, eine mögliche Ausgestaltung folgt aber unmittelbar aus der Darstellung in den Fig. 1 bis 5, bei welchen dann die gezeigten Sensoren 6 weggelassen werden können und stattdessen oder zusätzlich die Seite 22 als kapazitiver Sensor 6 verwendet wird.

Die Messelektrode 14 ist hier potentialfrei und somit gerade nicht mit einem Bezugspotential, speziell einem Massepotential, verbunden, sondern vielmehr unabhängig. Dies ist speziell in Fig. 5 erkennbar. Das gezeigte Photovoltaikmodul weist einen Pluspol 24 und einen Minuspol 26 auf, welche durch die Elektroden 18 der beiden Elektrodenschichten 8, 10 gebildet werden. Deutlich erkennbar ist in Fig. 2 und 3 auch die nicht explizit gekennzeichnete Sammelschiene (d.h. "bus bar"), welche am unteren Rand entlangläuft und zum Pluspol 24 führt. Der Minuspol 26 ist dagegen erkennbar an die mittige Elektrode 18 der unteren Elektrodenschicht 10 angeschlossen. Die Messelektrode 14 ist dann weder mit dem Pluspol 24 noch mit dem Minuspol 26 des Halbleitermoduls 2 verbunden, d.h. auch nicht mit dessen Zellen 32. Sofern ein jeweiliger Sensor 6, wie hier gezeigt, nur eine einzige Messelektrode 14 aufweist, weist das Halbleitermodul 2 auch lediglich einen einzelnen Anschlusspol 28 für den jeweiligen Sensor 6 auf.

Da die Elektrodenschichten 8, 10 ohnehin zur Realisierung der originären Funktion des Halbleitermoduls 2 strukturiert werden, wird dabei auch die Messelektrode 14 des Sensors 6 ausgebildet und hierzu sozusagen aus einer der Elektrodenschichten 8, 10 herausgeschnitten und vom Rest der Elektrodenschicht 8, 10 elektrisch isoliert. Im gezeigten Ausführungsbeispiel wird die Messelektrode 14 aus beiden Elektrodenschichten 8, 10 ausgebildet, grundsätzlich geeignet ist aber auch eine nicht explizit gezeigte Variante, bei welche die Messelektrode 14 nur aus einer der beiden Elektrodenschichten 8, 10 ausgebildet wird. Bei dem gezeigten Halbleitermodul 2 sind beide Elektrodenschichten 8, 10 strukturiert und weisen dadurch mehrere Teilbereiche 30 auf, welche galvanisch voneinander getrennt sind. Einer der mehreren Teilbereiche 30 bildet dann die Messelektrode 14. Die übrigen Teilbereiche 30 bilden dann jeweils eine Elektrode 18 einer jeweiligen Zelle 32 des Halbleitermoduls 2. Die Teilbereiche 30, welche Elektroden 18 sind, sind durch die Strukturierung zunächst voneinander getrennt, werden dann aber später mittels Zell-Durchkontaktierungen 34 miteinander elektrisch verbunden. In Fig. 5 sind die Teilbereiche 30 der Übersichtlichkeit halber nur für die untere Elektrodenschicht 10 gekennzeichnet, aus der Figur wird aber deutlich, dass auch die obere Elektrodenschicht 8 in Teilbereiche 30 unterteilt ist. Die Zellen 32 sind in den Fig. 4 und 5 durch zusätzliche, vertikale, gestrichelte Linien verdeutlicht. In den Fig. 2 und 3 sind die Zellen 32 aufgrund der Struktur der unteren Elektrodenschicht 10 ebenfalls gut erkennbar. In Fig. 1 wurde auf eine explizite Darstellung der Zellen 32 verzichtet, diese sind jedoch üblicherweise aufgrund der Strukturierung der aktiven Schicht 12 ebenfalls gut voneinander unterscheidbar. Die Lage einer Zelle 32 ist beispielhaft in den Fig. 1 und 2 mittels vertikaler, gestrichelter Linien verdeutlicht.

Im gezeigten Ausführungsbeispiel sind alle Zellen 32 seriell verschaltet und in einer einzelnen Reihe angeordnet. Diese Anordnung ist vorteilhaft für das in Fig. 7 gezeigte Gerät. Die Anordnung und Verschaltung ist aber nicht zwingend, sondern beliebig gestaltbar. In nicht gezeigten Ausgestaltungen sind die Zellen 32 z.B. in einer Matrix angeordnet oder anders geformt und/oder angeordnet und/oder die Zellen 32 sind sogar unterschiedlich dimensioniert. Auch eine Parallelschaltung ist möglich oder eine Verschaltung mit sowohl seriell als auch parallel verschalteten Zellen 32.

Die Größe, d.h. die Abmessung der Messelektrode 14 ist im Grunde beliebig gestaltbar und daher hier an den vorgesehenen Anwendungsfall angepasst. Dabei ist die Größe der Messelektrode 14 jedoch so gering wie möglich gewählt, um möglichst viel Fläche des Halbleitermoduls 2 für dessen erste, originäre Funktion zu erhalten. Bei der hier vorgesehenen Verwendung des Sensors 6 als Eingabeelement, zur Bedienung mit einem Finger, ist es ausreichend, wenn die Messelektrode 14 wie hier gezeigt mit quadratischer Form mit einer Kantenlänge K von 1 mm bis 10 mm ausgebildet ist, z.B. 8 mm.

Die hier gezeigte Messelektrode 14 ist - wie in Fig. 5 erkennbar ist - aus einem Oberteil 36, welches ein Teilbereich 30 der oberen Elektrodenschicht 8 ist, und einem Unterteil 38, welches ein Teilbereich 30 der unteren Elektrodenschicht 10 ist, gebildet, wobei das Oberteil 36 und das Unterteil 38 mittels einer Durchkontaktierung 40 durch die aktive Schicht 12 hindurch elektrisch verbunden sind. In dieser Ausgestaltung wird die Messelektrode 14 vollständig durch solche Verfahrensschritte hergestellt, welche auch zur Herstellung der Zellen 32 verwendet werden, z.B. wie weiter oben bereits beschrieben.

Wie bereits angedeutet, ist die Schichtstruktur 4 derart strukturiert, dass diese mehrere Zellen 32 aufweist. Die Durchkontaktierung 40 ist dabei dann gemeinsam mit einer oder mehreren weiteren Durchkontaktierungen 34 hergestellt, mittels welcher die Zellen 32 elektrisch verschaltet sind. Die Durchkontaktierungen 34 zum Verbinden der Zellen 32 werden auch als Zell-Durchkontaktierungen 34 bezeichnet. Beide Elektrodenschichten 8, 10 werden jeweils strukturiert, um die Elektroden 18 der Zellen 32 auszubilden, zugleich werden dabei das Oberteil 36 und das Unterteil 38 analog zu den Elektroden 18 ausgebildet, gegebenenfalls mit abweichender Form. Weiter werden ein oder mehrere Durchkontaktierungen 34 ausgebildet, welche durch die aktive Schicht 12 hindurchreichen und die Elektroden 18 elektrisch miteinander verbinden, um die Zellen 32 seriell oder parallel zu verschalten oder eine Kombination hiervon. Dabei wird dann auch zumindest eine Durchkontaktierung 40 ausgebildet, welche das Oberteil 36 mit dem Unterteil 38 verbindet, sodass diese dann kurzgeschlossen sind. Im hier gezeigten Ausführungsbeispiel sind das Oberteil 36 und das Unterteil 38 auch übereinanderliegend ausgebildet und gerade nicht zueinander versetzt sowie auch gleich groß und auch mit gleicher Form.

Vorliegend wird die jeweilige Durchkontaktierung 40 auch genutzt, um einem Benutzer die Position des Sensors 6 anzuzeigen. Dies ist besonders deutlich in Fig. 1 und Fig. 7 erkennbar. Die Durchkontaktierung 40 ist hierzu von außen sichtbar und markiert dadurch die Position des kapazitiven Sensors 6 im Halbleitermodul 2. Die Durchkontaktierung 40 wird demnach gezielt als Markierung verwendet, deren Herstellung vollständig in die Herstellung des Halbleitermoduls 2 integriert ist. Die Markierung des Sensors 6 erfolgt nämlich bei der Herstellung der Durchkontaktierungen 34, 40.

Die obere Elektrodenschicht 8 ist wie bereits beschrieben aus einem transparenten Material gefertigt. Dadurch sind die Durchkontaktierung 40 und die aktive Schicht 12 durch die obere Elektrodenschicht 8 hindurch sichtbar. Weiter ist die Durchkontaktierung 40 aus einem anderen Material als die aktive Schicht 12 hergestellt und hebt sich dadurch gegenüber der aktiven Schicht 12 optisch ab.

Eine jeweilige Durchkontaktierung 34, 40 wird dadurch hergestellt, dass die aktive Schicht 12 in einem Strukturierungsschritt strukturiert wird, d.h. das aktive Material bereichsweise entfernt oder von vornherein ausgelassen wird, und stattdessen dann elektrisch leitendes Material eingefügt wird. Vorliegend wird die Durchkontaktierung 40 der Messelektrode 14 gleichzeitig mit der unteren Elektrodenschicht 10 hergestellt und ist somit automatisch aus dem gleichen Material wie die untere Elektrodenschicht 10 hergestellt.

Zudem sind die hier gezeigten Durchkontaktierungen 40 in Form eines Schriftzeichens oder Bildzeichens ausgebildet. Dadurch lässt sich nicht nur die Position des Sensors 6 anzeigen, sondern auch eine damit verknüpfte Funktion angeben. Die hier gezeigten Schriftzeichen und/oder Bildzeichen sind logischerweise lediglich beispielhaft. Grundsätzlich ist es auch möglich, mehrere Durchkontaktierungen 40 für einen einzelnen Sensor 6 auszubilden, um komplexere Bilder oder Kombinationen mehrerer Schriftzeichen darzustellen.

In Fig. 7 ist dann - wie bereits angedeutet - ein Ausführungsbeispiel für ein Gerät 42 gezeigt, hier eine Tastatur, welche ein Halbleitermodul 2 mit mehreren kapazitiven Sensoren 6 aufweist, welche als Eingabeelemente für einen Mediaplayer dienen. Die sechs Durchkontaktierungen 40 (in Fig. 7 ist nur eine davon explizit gekennzeichnet) sind entsprechend als Bildzeichen ausgebildet und heben sich gegen die aktive Schicht 12 ab, um die Position der Sensoren 6 zu kennzeichnen. Das Halbleitermodul 2 in Fig. 7 entspricht dem Halbleitermodul 2 der Fig. 1 bis 5, andere Ausgestaltungen sind aber möglich. Das Gerät 42 weist aufgrund dessen Ausgestaltung als Tastatur zudem eine Vielzahl von Tasten auf, welche in Fig. 7 der Übersichtlichkeit halber nicht explizit beschriftet sind, eine mögliche Beschriftung mit Buchstaben, Zahlen und sonstigen Zeichen ist jedoch unmittelbar aus dem Layout der Tasten erkennbar.

Wie speziell in Fig. 2, 3 und 5 erkennbar ist, weist das Halbleitermodul 2 rückseitig eine hier beispielhaft kreisrunde Ausnehmung 44 auf, zum Anschließen der Messelektrode 14 an eine Auswerteeinheit 46. Die Ausnehmung 44 ist hier in eine Schutzhülle 20 des Halbleitermoduls 2 eingebracht, sodass die Messelektrode 14 elektrisch zugänglich ist. Analog weist das Halbleitermodul 2 auch zwei nicht explizit bezeichnete Ausnehmungen zum Anschließen der Zellen 32, genauer deren Elektroden 18 auf, d.h. Ausnehmungen für den Pluspol 24 und den Minuspol 26.

Eine Auswerteeinheit 46 für die Sensoren 6 ist in Fig. 7 in das Gerät 42 integriert. Die Messelektrode 14 sind dann an die Auswerteeinheit 46 angeschlossen, zur Auswertung eines Signals des jeweiligen Sensors 6.

### Bezugszeichenliste

- 2: Halbleitermodul
- 4: Schichtstruktur
- 6: Sensor
- 8: obere Elektrodenschicht
- 10: untere Elektrodenschicht
- 12: aktive Schicht
- 14: Messelektrode
- 16: Trägerschicht
- 18: Elektrode
- 20: Schutzhülle
- 22: Seite (der Schutzhülle)
- 24: Pluspol
- 26: Minuspol
- 28: Anschlusspol
- 30: Teilbereich
- 32: Zelle
- 34: Zell-Durchkontaktierung, Durchkontaktierung
- 36: Oberteil
- 38: Unterteil
- 40: Durchkontaktierung
- 42: Gerät
- 44: Ausnehmung
- 46: Auswerteeinheit

- K: Kantenlänge
- S1: erster Schritt
- S2: zweiter Schritt
- S3: dritter Schritt
- S4: vierter Schritt
- S5: fünfter Schritt

## Patentansprüche

1. Halbleitermodul (2), welches eine Schichtstruktur (4) und zumindest einen kapazitiven Sensor (6) aufweist,
- wobei die Schichtstruktur (4) eine obere Elektrodenschicht (8) und eine untere Elektrodenschicht (10) aufweist sowie eine aktive Schicht (12), welche zwischen den Elektrodenschichten (8, 10) angeordnet ist und aus einem Halbleitermaterial hergestellt ist,
- wobei der kapazitive Sensor (6) eine Messelektrode (14) aufweist, welche in die Schichtstruktur (4) integriert ist,
- **dadurch gekennzeichnet dass** die Messelektrode (14) aus einem Oberteil (36), welches ein Teilbereich (30) der oberen Elektrodenschicht (8) ist, und einem Unterteil (38), welches ein Teilbereich (30) der unteren Elektrodenschicht (10) ist, gebildet ist,
- wobei das Oberteil (36) und das Unterteil (38) mittels einer Durchkontaktierung (40) durch die aktive Schicht (12) hindurch elektrisch verbunden sind.

2. Halbleitermodul (2) nach Anspruch 1,
wobei dieses als ein organisches Photovoltaikmodul ausgebildet ist und hierzu die Schichtstruktur (4) zur Erzeugung von Strom mittels Absorption von Licht in der aktiven Schicht (12) ausgebildet ist.

3. Halbleitermodul (2) nach Anspruch 1 oder 2,
wobei die Messelektrode (14) potentialfrei ist.

4. Halbleitermodul (2) nach einem der Ansprüche 1 bis 3,
wobei zumindest eine der Elektrodenschichten (8, 10) strukturiert ist und dadurch mehrere Teilbereiche (30) aufweist, welche galvanisch voneinander getrennt sind,
wobei einer der mehreren Teilbereiche (30) die Messelektrode bildet (14).

5. Halbleitermodul (2) nach einem der Ansprüche 1 bis 4,
wobei die Durchkontaktierung (40) von außen sichtbar ist und dadurch die Position des kapazitiven Sensors (6) im Halbleitermodul (2) markiert.

6. Halbleitermodul (2) nach einem der Ansprüche 1 bis 5,
wobei die obere Elektrodenschicht (8) aus einem transparenten Material gefertigt ist, sodass die Durchkontaktierung (40) und die aktive Schicht (12) durch die obere Elektrodenschicht (10) hindurch sichtbar sind,
wobei die Durchkontaktierung (40) aus einem anderen Material als die aktive Schicht (12) hergestellt ist und sich dadurch gegenüber der aktiven Schicht (12) optisch abhebt.

7. Halbleitermodul (2) nach einem der Ansprüche 1 bis 6,
wobei die Durchkontaktierung (40) gleichzeitig mit der unteren Elektrodenschicht (10) hergestellt ist und aus dem gleichen Material wie die untere Elektrodenschicht (10).

8. Halbleitermodul (2) nach einem der Ansprüche 1 bis 7,
wobei die Durchkontaktierung (40) in Form eines Schriftzeichens oder Bildzeichens ausgebildet ist.

9. Halbleitermodul (2) nach einem der Ansprüche 1 bis 8,
wobei die Schichtstruktur (4) strukturiert ist, sodass diese mehrere Zellen (32) aufweist,
wobei die Durchkontaktierung (40) gemeinsam mit einer oder mehreren weiteren Durchkontaktierungen (34) hergestellt ist, mittels welcher die Zellen (32) elektrisch verschaltet sind.

10. Halbleitermodul (2) nach einem der Ansprüche 1 bis 9,
wobei dieses rückseitig eine Ausnehmung (44) aufweist, zum Anschließen der Messelektrode (14) an eine Auswerteeinheit (46).

11. Gerät (42), insbesondere Eingabegerät, welches ein Halbleitermodul (2) nach einem der Ansprüche 1 bis 10 aufweist und bei welchem der kapazitive Sensor (6) als ein Eingabeelement dient.

12. Verfahren zur Herstellung eines Halbleitermoduls (2) nach einem der Ansprüche 1 bis 10, welches eine Schichtstruktur (4) und zumindest einen kapazitiven Sensor (6) aufweist,
- wobei die Schichtstruktur (4) eine obere Elektrodenschicht (8) und eine untere Elektrodenschicht (10) aufweist sowie eine aktive Schicht (12), welche zwischen den Elektrodenschichten (8, 10) angeordnet ist und aus einem Halbleitermaterial hergestellt ist,
- wobei der kapazitive Sensor (6) eine Messelektrode (14) aufweist, welche in die Schichtstruktur (4) integriert wird,
- wobei die Messelektrode (14) aus einem Oberteil (36), welches ein Teilbereich (30) der oberen Elektrodenschicht (8) ist, und einem Unterteil (38), welches ein Teilbereich (30) der unteren Elektrodenschicht (10) ist, gebildet ist,
- wobei das Oberteil (36) und das Unterteil (38) mittels einer Durchkontaktierung (40) durch die aktive Schicht (12) hindurch elektrisch verbunden sind.

## Claims

1. Semiconductor module (2) comprising a layer structure (4) and at least one capacitive sensor (6),
- wherein the layer structure (4) comprises an upper electrode layer (8) and a lower electrode layer (10) and also an active layer (12), which is arranged between the electrode layers (8, 10) and is produced from a semiconductor material,
- wherein the capacitive sensor (6) comprises a measuring electrode (14) integrated into the layer structure (4),
- **characterized in that**
the measuring electrode (14) is formed from an upper part (36), which is a partial region (30) of the upper electrode layer (8), and a lower part (38), which is a partial region (30) of the lower electrode layer (10),
- wherein the upper part (36) and the lower part (38) are electrically connected by means of a via (40) through the active layer (12).

2. Semiconductor module (2) according to Claim 1,
wherein said semiconductor module is configured as an organic photovoltaic module and, for this purpose, the layer structure (4) is configured for generating current by means of absorption of light in the active layer (12).

3. Semiconductor module (2) according to Claim 1 or 2, wherein the measuring electrode (14) is potential-free.

4. Semiconductor module (2) according to any of Claims 1 to 3,
wherein at least one of the electrode layers (8, 10) is structured and thereby comprises a plurality of partial regions (30) which are electrically isolated from one another,
wherein one of the plurality of partial regions (30) forms the measuring electrode (14).

5. Semiconductor module (2) according to any of Claims 1 to 4,
wherein the via (40) is visible from outside and thereby marks the position of the capacitive sensor (6) in the semiconductor module (2).

6. Semiconductor module (2) according to any of Claims 1 to 5,
wherein the upper electrode layer (8) is fabricated from a transparent material, such that the via (40) and the active layer (12) are visible through the upper electrode layer (10),
wherein the via (40) is produced from a different material than the active layer (12) and thereby contrasts optically with the active layer (12).

7. Semiconductor module (2) according to any of Claims 1 to 6,
wherein the via (40) is produced simultaneously with the lower electrode layer (10) and from the same material as the lower electrode layer (10).

8. Semiconductor module (2) according to any of Claims 1 to 7,
wherein the via (40) is configured in the form of a graphic character or pictorial symbol.

9. Semiconductor module (2) according to any of Claims 1 to 8,
wherein the layer structure (4) is structured, such that the latter comprises a plurality of cells (32), wherein the via (40) is produced jointly with one or more further vias (34), by means of which the cells (32) are electrically interconnected.

10. Semiconductor module (2) according to any of Claims 1 to 9,
wherein said semiconductor module comprises a cutout (44) on the rear side, for the purpose of connecting the measuring electrode (14) to an evaluation unit (46) .

11. Device (42), in particular input device, which comprises a semiconductor module (2) according to any of Claims 1 to 10 and in which the capacitive sensor (6) serves as an input element.

12. Method for producing a semiconductor module (2) according to any of Claims 1 to 10, said semiconductor module comprising a layer structure (4) and at least one capacitive sensor (6),
- wherein the layer structure (4) comprises an upper electrode layer (8) and a lower electrode layer (10) and also an active layer (12), which is arranged between the electrode layers (8, 10) and is produced from a semiconductor material,
- wherein the capacitive sensor (6) comprises a measuring electrode (14) integrated into the layer structure (4),
- wherein the measuring electrode (14) is formed from an upper part (36), which is a partial region (30) of the upper electrode layer (8), and a lower part (38), which is a partial region (30) of the lower electrode layer (10),
- wherein the upper part (36) and the lower part (38) are electrically connected by means of a via (40) through the active layer (12).

## Revendications

1. Module semi-conducteur (2) qui présente une structure en couches (4) et au moins un capteur capacitif (6),
- dans lequel la structure en couches (4) comprend une couche d'électrode supérieure (8) et une couche d'électrode inférieure (10), ainsi qu'une couche active (12) qui est disposée entre les couches d'électrodes (8, 10) et qui est constituée d'un matériau semi-conducteur,
- dans lequel le capteur capacitif (6) comporte une électrode de mesure (14) qui est intégrée dans la structure en couches (4),
- **caractérisé en ce que**
l'électrode de mesure (14) est formée d'une partie supérieure (36), qui est une zone partielle (30) de la couche d'électrode supérieure (8), et d'une partie inférieure (38), qui est une zone partielle (30) de la couche d'électrode inférieure (10),
- dans lequel la partie supérieure (36) et la partie inférieure (38) sont reliées électriquement par l'intermédiaire d'un contact traversant (40) à travers la couche active (12).

2. Module semi-conducteur (2) selon la revendication 1,
dans lequel celui-ci est conçu sous la forme d'un module photovoltaïque organique et, à cet effet, la structure en couches (4) est conçue pour produire un courant par absorption de lumière dans la couche active (12).

3. Module semi-conducteur (2) selon la revendication 1 ou 2,
dans lequel l'électrode de mesure (14) est sans potentiel.

4. Module semi-conducteur (2) selon l'une des revendications 1 à 3,
dans lequel au moins l'une des couches d'électrodes (8, 10) est structurée et présente de ce fait de multiples zones partielles (30) qui sont séparées galvaniquement les unes des autres,
dans lequel l'une des multiples zones partielles (30) forme l'électrode de mesure (14).

5. Module semi-conducteur (2) selon l'une des revendications 1 à 4,
dans lequel le contact traversant (40) est visible de l'extérieur et marque de ce fait la position du capteur capacitif (6) dans le module semi-conducteur (2).

6. Module semi-conducteur (2) selon l'une des revendications 1 à 5,
dans lequel la couche d'électrode supérieure (8) est faite d'un matériau transparent, de telle sorte que le contact traversant (40) et la couche active (12) sont visibles à travers la couche d'électrode supérieure (10), dans lequel le contact traversant (40) est constitué d'un matériau différent de celui de la couche active (12) et se distinguant ainsi optiquement de la couche active (12) .

7. Module semi-conducteur (2) selon l'une des revendications 1 à 6,
dans lequel le contact traversant (40) est fabriqué en même temps que la couche d'électrode inférieure (10) et à partir du même matériau que la couche d'électrode inférieure (10).

8. Module semi-conducteur (2) selon l'une des revendications 1 à 7,
dans lequel le contact traversant (40) est conçu sous la forme d'un caractère ou d'une image.

9. Module semi-conducteur (2) selon l'une des revendications 1 à 8,
dans lequel la structure en couches (4) est structurée de telle sorte que celle-ci présente plusieurs cellules (32),
dans lequel le contact traversant (40) est fabriqué en même temps qu'un ou plusieurs autres contacts traversants (34) au moyen desquels les cellules (32) sont électriquement connectées.

10. Module semi-conducteur (2) selon l'une des revendications 1 à 9,
dans lequel celui-ci présente à l'arrière un évidement (44) destiné au raccordement de l'électrode de mesure (14) à une unité d'évaluation (46).

11. Appareil (42), en particulier appareil de saisie, qui présente un module semi-conducteur (2) selon l'une des revendications 1 à 10 et dans lequel le capteur capacitif (6) sert d'élément de saisie.

12. Procédé de fabrication d'un module semi-conducteur (2) selon l'une des revendications 1 à 10, qui présente une structure en couches (4) et au moins un capteur capacitif (6),
- dans lequel la structure en couches (4) comprend une couche d'électrode supérieure (8) et une couche d'électrode inférieure (10), ainsi qu'une couche active (12) qui est disposée entre les couches d'électrodes (8, 10) et qui est constituée d'un matériau semi-conducteur,
- dans lequel le capteur capacitif (6) comporte une électrode de mesure (14) qui est intégrée dans la structure en couches (4),
- dans lequel l'électrode de mesure (14) est formée d'une partie supérieure (36), qui est une zone partielle (30) de la couche d'électrode supérieure (8), et d'une partie inférieure (38), qui est une zone partielle (30) de la couche d'électrode inférieure (10),
- dans lequel la partie supérieure (36) et la partie inférieure (38) sont reliées électriquement par l'intermédiaire d'un contact traversant (40) à travers la couche active (12).
